Europäisches Patentamt

(19) **European Patent Office**

Office européen des brevets

(11) Veröffentlichungsnummer: **0 082 381**
**B1**

(12) **EUROPÄISCHE PATENTSCHRIFT**

(45) Veröffentlichungstag der Patentschrift:
**20.11.86**

(51) Int. Cl.⁴: **H 03 G 3/20,** H 03 G 7/00

(21) Anmeldenummer: **82111229.9**

(22) Anmeldetag: **04.12.82**

(54) **Elektronischer Verstärker.**

(30) Priorität: **19.12.81 DE 3150436**

(43) Veröffentlichungstag der Anmeldung:
**29.06.83 Patentblatt 83/26**

(45) Bekanntmachung des Hinweises auf die Patenterteilung:
**20.11.86 Patentblatt 86/47**

(84) Benannte Vertragsstaaten:
**AT BE CH DE FR GB IT LI NL SE**

(56) Entgegenhaltungen:
**EP - A - 0 041 310**
**DE - A - 1 915 511**
**DE - A - 2 924 373**
**US - A - 3 848 194**

**FUNKSCHAU, Band 53, Nr. 24, November 1981, Seiten 67-69, MÜNCHEN (DE). L.A. ABBAGNARO, "CX - Mehr Störabstand für Schallplatten".**
**WIRELESS WORLD, Band 84, Nr. 1511, Juli 1978, Seite 74, LONDON (GB). L. MAYES, "Audio Compressor".**
**FUNKSCHAU, Band 47, Nr. 10/213, 1975, Seiten 81 - 82, MÜNCHEN (DE). E. KOCH, "Studiovorverstärker mit Dynamikkompressor und Anzeigeverstärker".**

(73) Patentinhaber: **TELEFUNKEN Fernseh und Rundfunk GmbH, Göttinger Chaussee 76, D-3000 Hannover 91 (DE)**

(72) Erfinder: **Schröder, Ernst, Dipl.-Ing., Pinkenburger Strasse 25D, D-3000 Hannover 51 (DE)**

(74) Vertreter: **Einsel, Robert, Dipl.-Ing., TELEFUNKEN Fernseh und Rundfunk GmbH Göttinger Chaussee 76, D-3000 Hannover 91 (DE)**

## Beschreibung

Die Erfindung betrifft einen elektronischen Verstärker mit vorbestimmter Grundverstärkung und mit einer Schaltung zur Erzeugung einer Steuerspannung zur Regelung der Verstärkung des Verstärkers.

Bei Verstärkern ist es bekannt, durch eine Steuerschaltung die Grundverstärkung so zu ändern, dass die Verstärkung für Signale grösserer oder kleinerer Amplitude als eines vorbestimmten Wertes unterschiedlich gross ist. Dieses Prinzip wird z.B. bei Kompandern angewendet. Es ist auch bekannt (Wireless World, July 1978, S. 74), einen Audio-Kompressor mittels eines Schalters in einen Verstärker mit fester oder veränderbarer Steuerspannung umzuschalten.

Es ist weiterhin ein Verstärker unter der Bezeichnung CX bekannt geworden, bei dem die Verstärkung durch eine nichtlineare Filteranordnung mit einem integrierenden und einem differenzierenden Zweig zu regeln ist, wobei der differenzierende Zweig noch durch eine Ventilschaltung nur bei ansteigender Steuerspannung wirksam sein soll (Funkschau 1981, Band 53, Nr. 24, S. 67–69). Bei dieser den Oberbegriff des Anspruchs 1 bildenden Schaltung ist der Verstärkungsfaktor für eine bestimmte Eingangsspannung Eins und für andere Eingangsspannungen grösser oder kleiner als Eins.

Der Erfindung liegt die Aufgabe zugrunde, bei einem elektronischen Verstärker mit wahlweisem Betrieb als neutralem oder dynamisch steuerbarem Verstärker Störungen aufgrund eines Übersprechens der Steuerspannung in dem Nutzsignalweg zu vermeiden. Diese Aufgabe wird durch die im Anspruch 1 angegebenen Merkmale gelöst. Weiterbildungen der Erfindung sind in den Unteransprüchen angegeben.

Zur näheren Erläuterung der Erfindung werden im folgenden zwei Ausführungsbeispiele anhand der Zeichnungen erläutert. Diese zeigen in

Fig. 1 einen Verstärker mit Steuerschaltung und mit einschaltbarem Nebenweg,
Fig. 2 einen Verstärker mit Steuerschaltung und mit nichtlinearem Filter im Steuerweg,
Fig. 3 eine erfindungsgemässe Weiterbildung der in Fig. 2 dargestellten Schaltung und in
Fig. 4 eine Weiterbildung der in Fig. 3 dargestellten Schaltung.

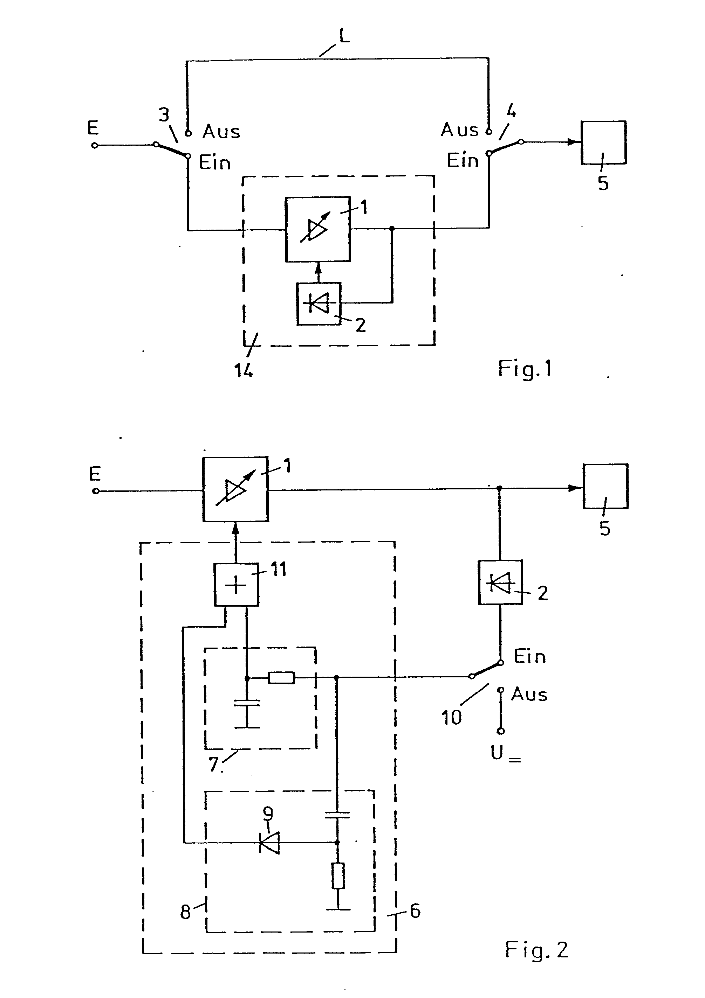

In Fig. 1 ist ein Verstärker 1 dargestellt, dessen Verstärkungsgrad durch eine Steuerschaltung 2 veränderbar ist. Die Steuerschaltung 2 erzeugt ihre Steuergleichspannung für den Verstärker in Abhängigkeit von der Signalspannung, die vor oder hinter dem Verstärker abgegriffen wird. Zusammen mit der Steuerkennlinie des Verstärkers 1 und der Übertragungskennlinie der Steuerschaltung 2 ergibt sich daraus ein bestimmter Verlauf der signalabhängigen Verstärkung der gesamten Anordnung 14 (siehe IEE Proc. Vol. 111, Nr. 3, March 1964, Seite 510). Bei dem hier dargestellten Verstärker werden die Signale hinter dem Verstärker abgegriffen.

Die zu verstärkenden Signale werden dem Verstärker 1 von einer Eingangsklemme E über einen Umschalter 3 zugeführt. Die verstärkten Signale gelangen über einen Umschalter 4 zu einem Verbraucher 5, z.B. einem weiteren Verstärker. Die beiden nicht mit dem Verstärker 1 verbundenen Klemmen der Schalter 3 und 4 sind miteinander über eine Leitung L verbunden, die praktisch einen Umgehungsweg (by-pass) für den Verstärker 1 bildet. Die Bezeichnungen EIN–AUS an den Schaltern 3 und 4 kennzeichnen daher die Wirksamkeit des Verstärkers 1 hinsichtlich der Signale. Der Aufwand für die soweit beschriebene Umschaltungsanordnung ist relativ hoch. Insbesondere werden signalführende Leitungen geschaltet, was z.B. bei räumlicher Trennung der Schalter 3, 4 von der Schaltung 14 aufwendige Abschirmmassnahmen nötig macht.

Dieser Aufwand kann herabgesetzt werden, indem die Steuerspannung für den Verstärker 1 auf einen festen Wert gelegt wird. Dieser feste Wert kann z.B. dem neutralen Punkt der Verstärkungscharakteristik entsprechen. Als neutralen Punkt bezeichnet man üblicherweise den Punkt der Versätrkungskennlinie, bei dem das Ausgangssignal dem Eingangssignal entspricht. Der feste Wert muss dem neutralen Punkt aber nicht notwendigerweise entsprechen. Eine Abweichung des festen Wertes vom neutralen Punkt hätte zur Folge, dass die Verstärkung des Verstärkers 1 durch die feste Steuerspannung auf einen Wert grösser oder kleiner als Eins festgelegt wird. Dies kann z.B. bei der Übertragung elektroakustischer Signale notwendig sein, um einen hörphysiologisch gleichen Lautheitseindruck in Stellung «EIN» und «AUS» zu erhalten.

Die Umschaltstelle wird zwischen den Ausgang der Steuerschaltung 2 und den Eingang des Verstärkers 1 gelegt. Besonders günstig ist diese Umschaltung lösbar bei einer Steuerschaltung 2, deren Steuergleichspannung über eine Filteranordnung 6 nach dem CX-Prinzip zum Verstärker 1 geführt wird.

Fig. 2 zeigt eine solche Schaltung. Dabei ist es zweckmässig, die Umschaltung vor die nichtlineare Filteranordnung 6 zu legen, um Störungen auf den Leitungen zwischen Steuerschaltung 2 und Schalter 10 vom steuerbaren Verstärker 1 fernzuhalten. Die Signale gelangen in Fig. 2 von der Eingangsklemme E direkt zum Verstärker 1 und vom Ausgang des Verstärkers 1 zum Eingang der Steuerschaltung 2. Die Steuergleichspannung der Steuerschaltung 2 gelangt über einen Umschalter 10 zum Eingang der Filteranordnung 6. Diese enthält zwei parallel angeordnete Filter 7 und 8, deren Ausgangs-Signale in einer Additionsschaltung 11 addiert werden. In der Filterschaltung 8 wirkt die Steuerspannung differenziert, wobei das Ventil 9 nur die ansteigenden Teile der Steuerspannung weiterleitet. Das Filter 7 integriert die Steuergleichspannung. Bei einem entsprechenden Ausführungsbeispiel werden die Schaltungen so bemessen, dass die Steuerspannung einen Nutzbereich von 0,5 V bis

10 V hat und der neutrale Punkt bei 5 V liegt. Betätigt man nun den Schalter 10 z.B. in einer Modulationspause, so springt die Spannung am Eingang der Filterschaltung 6 von 0,5 V auf 5 V. Dieser Sprung wird über den differenzierenden Zweig 8 sofort an den Verstärker 1 weitergegeben.

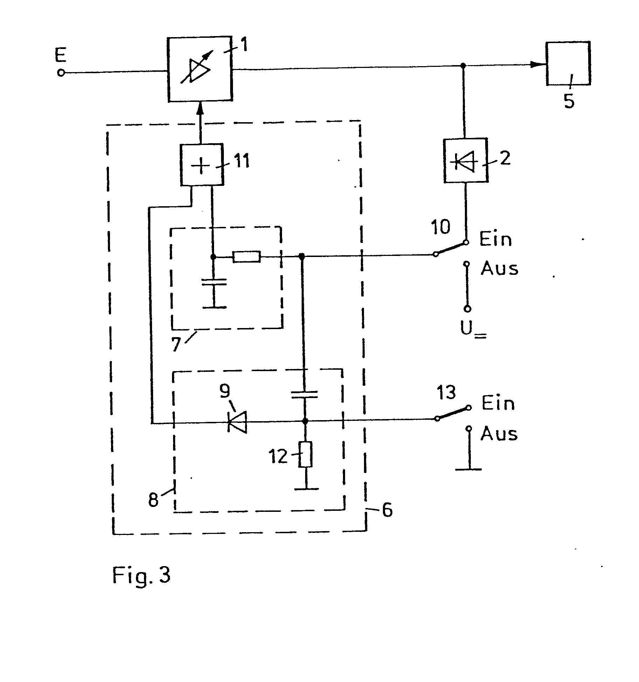

Steuerbare Verstärker leiden immer mehr oder weniger unter dem Problem des Übersprechens der Steuerspannung in den Nutzsignalweg. Eine schnelle Änderung der Steuerspannung führt dabei zu einem «Plopp»-Geräusch. Wenn Nutzsignal anliegt und das Nutzsignal selber durch eigenen Anstieg einen Anstieg der Steuerspannung hervorruft, so wird dieses Störgeräusch durch das Signal selber verdeckt. Liegt aber keine Modulation an, so würde das Geräusch beim Betätigen des Schalters 10 in Richtung «AUS» stören. Diese Störung wird durch die erfindungsgemässe Schaltung nach Fig. 3 vermieden.

In Fig. 3 ist parallel zum Widerstand 12 des Filters 8 ein den differenzierenden Kanal des Filters 8 sperrender Schalter 13 angeordnet, der gleichzeitig mit dem Schalter 10 betätigt wird. Die Steuerspannung am Verstärker 1 steigt dann im o.a. Beispiel infoge der integrierenden Wirkung der Schaltung 7 nur relativ langsam von 0,5 V auf 5 V und das «Plopp»-Geräusch bleibt unhörbar.

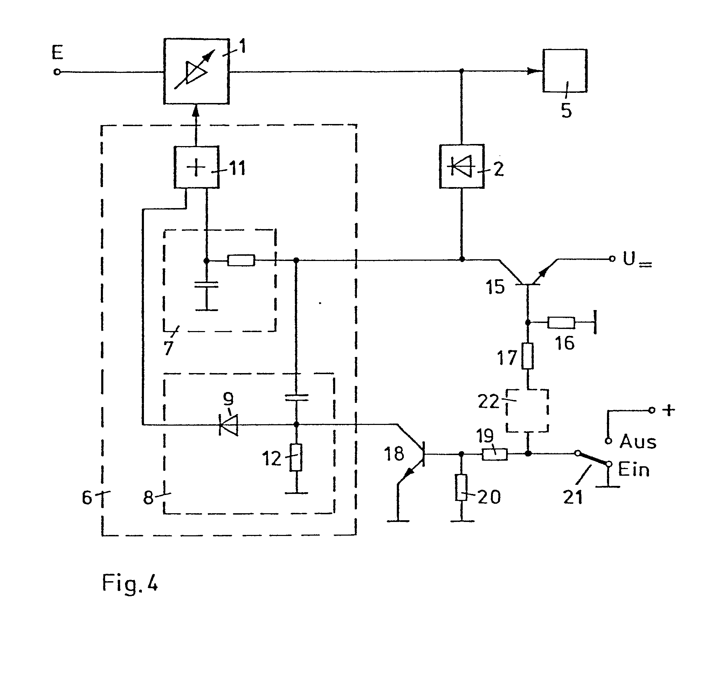

Fig. 4 zeigt eine vorteilhafte Weiterbildung der Fig. 3, die sich insbesondere zur Anwendung in einem monolithisch integrierten Schaltkreis eignet. Die Schalter 10 und 13 sind hier durch die als Schalter wirkenden Transistoren 15 und 18 ersetzt. Werden die Basisspannungsteiler 17, 16 bzw. 19, 20 über den Schalter 21 mit Masse verbunden («EIN»), so sind die Transistoren gesperrt, d.h. ihre Kollektor-Emitterstrecken sind hochohmig und damit wirkungslos. In der anderen Stellung des Schalters 21 werden die Spannungsteiler mit einer positiven Betriebsspannung verbunden («AUS»). Dadurch werden die Kollektor-Emitterstrecken der Transistoren 15 und 18 niederohmig. Der Ausgang der Steuerschaltung 2 wird dadurch über den Transistor 15 niederohmig mit einer festen Spannung verbunden. Der niederohmige Transistor 18 schliesst den Eingang der Schaltung 8 kurz.

Der Schalter 13 (Fig. 3) kann um eine kurze Zeit (1 ms) vor dem Schalter 10 betätigt werden. Damit werden auch geringfügige Störungen, die sonst den differenzierenden Zweig vor dem Schliessen des Schalters 13 noch passieren könnten, mit Sicherheit ausgeschlossen. Die zeitliche Verschiebung wird in einer Schaltung gemäss Fig. 3 dadurch erreicht, dass die mechanischen Schalter 10 und 13 so gekuppelt sind, dass beim Betätigungsvorgang der Schalter 13 eher geschlossen wird. Bei einer Schaltung nach Fig. 4 kann in die Steuerleitung zum Transistor 15 ein Verzögerungsglied 22 eingefügt werden.

## Patentansprüche

1. Elektronischer Verstärker (1) mit vorbestimmter Grundverstärkung und mit einer Schaltung (2) zur Erzeugung einer Steuerspannung zur Regelung der Verstärkung des Verstärkers (1) und mit einer nichtlinearen Filteranordnung (6) mit wenigstens einem integrierenden (Tiefpass) Zweig (7) und einem differenzierenden (Hochpass) Zweig (8), bei der dem differenzierenden Zweig (8) eine Ventilschaltung (9) zugeordnet ist, derart, dass der Zweig (8) nur bei ansteigender Steuerspannung wirksam ist, wobei der Verstärker (1) und die Schaltung (2) so bemessen sind, dass der Verstärkungsfaktor für eine bestimmte Eingangsspannung Eins ist und dass der Verstärkungsfaktor für andere Eingangsspannungen grösser oder kleiner als Eins ist, dadurch gekennzeichnet, dass ein Schalter (10) vorgesehen ist, durch den der Verstärker (1) und die Schaltung (2) auf eine Betriebsweise mit der unveränderlichen Grundverstärkung umschaltbar sind, und dass parallel zum differenzierenden Zweig (8) des Filters (6) ein zusätzlicher Schalter (13) geschaltet ist, der so mit dem Schalter (10) gekuppelt ist, dass der differenzierende Zweig (8) gesperrt ist, wenn dem Verstärker (1) eine feste Steuerspannung zugeführt wird.

2. Verstärker nach Anspruch 1, dadurch gekennzeichnet, dass dem neutralen Punkt der Verstärkerkennlinie der Verstärkungsfaktor Eins entspricht.

3. Verstärker nach Anspruch 2, dadurch gekennzeichnet, dass die Steuerspannung zur Erreichung einer konstanten Verstärkung auf einen festen Wert schaltbar ist, der dem neutralen Punkt der Verstärkerkennlinie entspricht.

4. Verstärker nach Anspruch 1, dadurch gekennzeichnet, dass die Steuerspannung zur Erreichung einer konstanten Verstärkung auf einen festen Wert schaltbar ist, der vom neutralen Punkt abweicht.

5. Verstärker nach einem der Ansprüche 1 bis 4, dadurch gekennzeichnet, dass die Umschaltung auf den festen Wert zwischen dem Ausgang der Steuerschaltung (2) und dem Regeleingang des Verstärkers (1) erfolgt.

6. Verstärker nach einem der Ansprüche 1 bis 5, dadurch gekennzeichnet, dass die Umschaltung zwischen dem Ausgang der Steuerschaltung (2) und dem Eingang der nichtlinearen Filteranordnung (6) erfolgt.

7. Verstärker nach Anspruch 1 bis 6, dadurch gekennzeichnet, dass der zusätzliche Schalter (13) so mit dem Schalter (10) gekuppelt ist, dass er den Zweigweg (8) sperrt, kurz bevor der Schalter (10) an die feste Spannung gelegt wird.

## Claims

1. Electronic amplifier (1) having a predetermined reference amplification, a circuit (2) for producing a control voltage for the control of the amplification of the amplifier (1) and a non-linear filter arrangement (6) having at least an integrating (low pass) branch (7) and a differentiating (high pass) branch (8), in which filter a valve circuit (9) is associated with the differentiating branch (8) in such a way that the branch (8) is effective only with increasing control voltage, wherein the amplifier (1) and the circuit (2) are so dimensioned that the amplification factor is unity for a particular input voltage and the amplification factor is greater or less than unity for other input voltages, characterized in that a switch (10) is provided by which the amplifier (1) and the circuit (2) can be switched over to a mode of operation having the invariant reference amplification, and an additional switch (13) is connected parallel to the differentiating branch (8) of the filter (6) which is so coupled to the circuit (10) that the differentiating branch is blocked if a fixed control voltage is applied to the amplifier (1).

2. Amplifier according to Claim 1, characterized in that the amplification factor unity corresponds to the neutral point of the amplification characteristic.

3. Amplifier according to Claim 2, characterized in that in order to achieve a constant amplification the control voltage is switchable to a fixed value, which corresponds to the neutral point of the amplification characteristic.

4. Amplifier according to Claim 1, characterized in that in order to achieve a constant amplification the control voltage is switchable to a fixed value, which deviates from the neutral point.

5. Amplifier according to any one of the Claims 1 to 4, characterized in that the switchover to the fixed value occurs between the output of the control circuit (2) and the control input of the amplifier (1).

6. Amplifier according to any one of the Claims 1 to 5, characterized in that the switchover occurs between the output of the control circuit (2) and the input of the non-linear filter arrangement (6).

7. Amplifier according to Claims 1 to 6, characterized in that the additional switch (13) is so coupled with the switch (10) that it blocks the branch path (8) shortly before the switch (10) is applied to the fixed voltage.

**Revendications**

1. Amplificateur électronique (1) ayant une amplification de base prédéterminée et comportant un circuit (2) servant à produire une tension de commande en vue de la régulation de l'amplification de l'amplificateur (1), ainsi qu'un dispositif de filtrage non linéaire (6) comportant au moins une branche d'intégration (filtrage passe-bas) (7) et une branche de différentiation (filtrage passe-haut) (8), dans lequel un circuit de valve (9) est coordonné à la branche de différentiation (8) de telle sorte que la branche (8) se trouve en action seulement lors d'un accroissement de la tension de commande, l'amplificateur (1) et le circuit (2) étant dimensionnés de telle sorte que la facteur d'amplification soit égal à 1 pour une tension d'entrée déterminée, et que ce facteur d'amplification soit supérieur ou inférieur à 1 pour d'autres tensions d'entrée, caractérisé en ce qu'il est prévu un commutateur (10) à l'aide duquel l'amplificateur (1) et le circuit (2) sont commutables vers un mode de fonctionnement avec l'amplification de base non variable, et en ce qu'il est prévu en parallèle à la branche de différentiation (8) du filtre (6) un commutateur additionnel (13) qui est couplé avec le commutateur (10) de telle sorte que la branche de différentiation (8) soit bloquée lorsque l'amplificateur (1) reçoit une tension de commande fixe.

2. Amplificateur selon la revendication 1, caractérisé en ce que le point neutre de la courbe caractéristique d'amplification correspond au facteur d'amplification 1.

3. Amplificateur selon la revendication 2, caractérisé en ce que, pour atteindre une amplification constante, la tension de commande peut être commutée à une valeur fixe qui correspond au point neutre de la courbe caractéristique d'amplification.

4. Amplificateur selon la revendication 1, caractérisé en ce que pour atteindre une amplification constante la tension de commande peut être commutée à une valeur fixe qui est différente du point neutre.

5. Amplificateur selon une des revendications 1 à 4, caractérisé en ce que la commutation à la valeur fixe est effectuée entre la sortie du circuit de commande (2) et l'entrée de régulation de l'amplificateur (1).

6. Amplificateur selon une des revendications 1 à 5, caractérisé en ce que la commutation est effectuée entre la sortie du circuit de commande (2) et l'entrée du dispositif de filtrage non linéaire (6).

7. Amplificateur selon une des revendications 1 à 6, caractérisé en ce que le commutateur additionel (13) est couplé avec le commutateur (10) de façon à bloquer la branche de dérivation (8) à un moment précédant de peu la mise à la tension fixe du commutateur (10).

0 082 381

Fig.1

Fig. 2

Fig. 3

Fig. 4